(19) **Europäisches Patentamt / European Patent Office / Office européen des brevets**

(11) **EP 1 354 360 B1**

(12) **FASCICULE DE BREVET EUROPEEN**

(45) Date de publication et mention de la délivrance du brevet:
**13.08.2008 Bulletin 2008/33**

(21) Numéro de dépôt: **02702446.2**

(22) Date de dépôt: **25.01.2002**

(51) Int Cl.:
*H01L 27/146* (2006.01)

(86) Numéro de dépôt international:
**PCT/FR2002/000326**

(87) Numéro de publication internationale:
**WO 2002/059974 (01.08.2002 Gazette 2002/31)**

(54) **ELEMENT PHOTOELECTRIQUE A TRES GRANDE DYNAMIQUE DE FONCTIONNEMENT**

PHOTOELEKTRISCHES ELEMENT MIT SEHR GROSSEM DYNAMIKBEREICH

PHOTOELECTRIC ELEMENT WITH HIGH OPERATING DYNAMICS

(84) Etats contractants désignés:
**DE ES FR GB IT SE**

(30) Priorité: **25.01.2001 FR 0101001**

(43) Date de publication de la demande:
**22.10.2003 Bulletin 2003/43**

(73) Titulaire: **New Imaging Technologies**
**91011 Evry Cedex (FR)**

(72) Inventeur: **NI, Yang**
**F-91120 Palaiseau (FR)**

(74) Mandataire: **Le Forestier, Eric et al**
**Cabinet Régimbeau**
**20, rue de Chazelles**
**75847 Paris cedex 17 (FR)**

(56) Documents cités:
**US-A- 4 633 086**  **US-A- 5 665 959**
**US-A- 5 869 857**

• **NI Y ET AL: "CMOS COMPATIBLE PHOTORECEPTOR FOR HIGH-CONTRAST CAR VISION" INTELLIGENT VEHICLE HIGHWAY SYSTEMS. BOSTON, NOV. 2 - 4, 1994, BELLINGHAM, SPIE, US, 1994, pages 246-252, XP000689132 ISBN: 0-8194-1677-0 cité dans la demande**
• **PATENT ABSTRACTS OF JAPAN vol. 1997, no. 12, 25 décembre 1997 (1997-12-25) -& JP 09 205588 A (CANON INC), 5 août 1997 (1997-08-05)**
• **YANG NI: "A CMOS Log Image Sensor with on-chip FPN Compensation" ESSCIRC 2001, 18 - 20 septembre 2001, XP002182065 Villag, Austria**
• **ANTON KRUGER: "How does a photodiode work" CHIPCENTRE QUESTLINK, XP002182066 www.chipcenter.com**
• **KAVADIAS ET AL: "A Logarithmic Response CMOS Image Sensor with On-Chip Calibration" IEEE JOURNAL OF SOLID-STATE CIRCUITS, vol. 35, no. 8, août 2000 (2000-08), pages 1146-1152, XP011061302**

**EP 1 354 360 B1**

## Description

L'invention concerne des capteurs d'images composés d'éléments photoélectriques à très grande dynamique de fonctionnement.

On connaît déjà des éléments photoélectriques utilisés dans des capteurs d'images matriciels fonctionnant selon une loi de conversion photoélectrique linéaire. Cette conversion linéaire limite la plage dynamique des signaux optiques à l'entrée d'un capteur. Ainsi, des mécanismes complexes comme l'ajustement de l'ouverture de l'objectif, le contrôle automatique de gain, etc., sont nécessaires afin d'éviter la saturation des éléments photoélectriques du capteur. Si ce genre de capteur d'images fonctionne bien en situation normale, il fonctionne mal ou pas du tout dans des situations difficiles comme la vision automobile par exemple, ou bien pour l'analyse d'images dans des environnements difficiles. En effet, soit les éléments photoélectriques sont trop sensible et ils saturent vite sous forte luminosité, soit ils sont trop peu sensibles et ils ne peuvent assurer une vision en pénombre ou nocturne.

On pourrait utiliser un élément photoélectrique dont la conversion photoélectrique vérifie une loi non linéaire, et notamment une loi logarithmique. Les capteurs constitués de ce type d'élément photoélectrique démontrent une plage dynamique très étendue par rapport à des capteurs équipés des éléments photoélectriques linéaires. Mais de tels éléments photoélectriques non linéaires présentent une forte dispersion paramétrique entre eux, au sein d'une même matrice. Cela crée un bruit spatial fixe typique à ce genre de capteur. De ce fait, l'image de sortie d'un capteur de ce type n'est pas exploitable si ce bruit spatial fixe n'est pas compensé. Les capteurs d'images logarithmiques actuels utilisent une méthode de compensation à l'extérieur du capteur matriciel. Elle consiste à capter une image de référence (une image dans une obscurité absolue), ensuite cette image sera stockée dans une mémoire numérique après une conversion analogique-numérique. A l'utilisation, chaque image captée par le capteur sera numérisée et soustraite par l'image de référence préalablement acquise. Car le bruit spatial fixe se présente souvent sous la forme additive. Mais cette méthode fonctionne bien quand le bruit spatial fixe ne change pas avec les paramètres environnementaux, ce qui n'est pas le cas dans la plupart des applications. En effet, la variation de nombreux paramètres peut engendrer une variation du bruit spatial fixe, donc rend l'image de référence imprécise voir inutilisable. L'acquisition d'une nouvelle image de référence est donc nécessaire, ce qui n'est pas .facile à gérer dans un système de vision car cela implique un problème de rapidité. En effet, les systèmes connus utilisent un cache venant se placer sur le capteur de manière à obtenir une obscurité absolue. Ceci est très complexe et les mécanismes mis en jeux sont incompatibles avec la notion de rapidité exigible à l'utilisation. Un tel système est décrit dans l'article de U. Seger et al.,

"Development of an Image Sensor with Enhanced Dynamic Range in Standard CMOS Technology", Proc. of Second Prometheus Workshop, vol. II, Institut for Microeletronics Stuggart, p. 371, Germany, 1989.

On connait aussi de US-A-4633086 un détecteur d'images infrarouge comportant une pluralité de photocapteurs comprenant un élément photo-électrique que l'on vient court-circuiter temporairement pour réduire globalement un rapport signal sur bruit du détecteur.

Le but de l'invention est de fournir un système d'acquisition d'images de référence très simple et peu gourmand en énergie.

Pour cela, on prévoit, selon l'invention, un photocapteur selon la revendication 1.

Avantageusement :

- le photocapteur comporte au moins un moyen de mémorisation pour mémoriser l'une des deux lectures.
- les moyens pour combiner sont un circuit différentiateur.
- le ou chaque élément de mémorisation est analogique.
- le ou chaque élément de mémorisation est numérique.
- le photocapteur comporte deux éléments de mémorisation.

On prévoit aussi, selon l'invention, un capteur matriciel d'images comportant une pluralité de photocapteurs présentant au moins l'une des caractéristiques précédentes.

On prévoit aussi, selon l'invention, un procédé de lecture destiné à être mis en oeuvre dans un photocapteur présentant au moins une des caractéristiques précédentes, et comprenant les étapes suivantes :

- sélection d'un élément photoélectrique ;
- première lecture de l'élément photoélectrique avec son interrupteur dans une première position ;
- mémorisation de la lecture dans l'élément de mémorisation ;
- deuxième lecture de l'élément photoélectrique avec son interrupteur dans une deuxième position; et
- combinaison des première et seconde lectures par les moyen pour combiner, pour obtenir le signal de sortie.

Avantageusement :

- la combinaison est une différence ;
- le procédé comporte en outre une étape de mémorisation de la deuxième lecture dans le second élément de mémoire.

On prévoit, selon l'invention, un procédé destiné à être mis en oeuvre dans un capteur matriciel tel que précédemment décrite, le procédé comportant les étapes suivantes :

- sélection d'un photocapteur ; et
- mise en oeuvre du procédé précédemment décrit dans le photocapteur sélectionné.

D'autres caractéristiques et avantages de l'invention apparaîtront lors de la description ci-après d'un mode préféré de réalisation. Aux dessins annexés :

- la figure 1 est un schéma d'un élément photoélectrique selon l'invention ;
- la figure 2 est un schéma d'un modèle de fonctionnement de l'élément photoélectrique de la figure 1 ;
- la figure 3 est un schéma d'une partie d'une matrice de capteur d'image comportant deux photocapteurs juxtaposés, chaque photocapteur comprenant deux éléments photoélectriques de la figure 1 ;
- la figure 4 est un schéma de principe d'une matrice de capteur d'image ;
- la figure 5 est un schéma de câblage de circuit pour la réalisation de l'élément photoélectrique de la figure 1 ; et
- les figures 6 et 7 sont un exemple d'image prise par un matrice comportant des éléments photoélectriques de la figure 1.

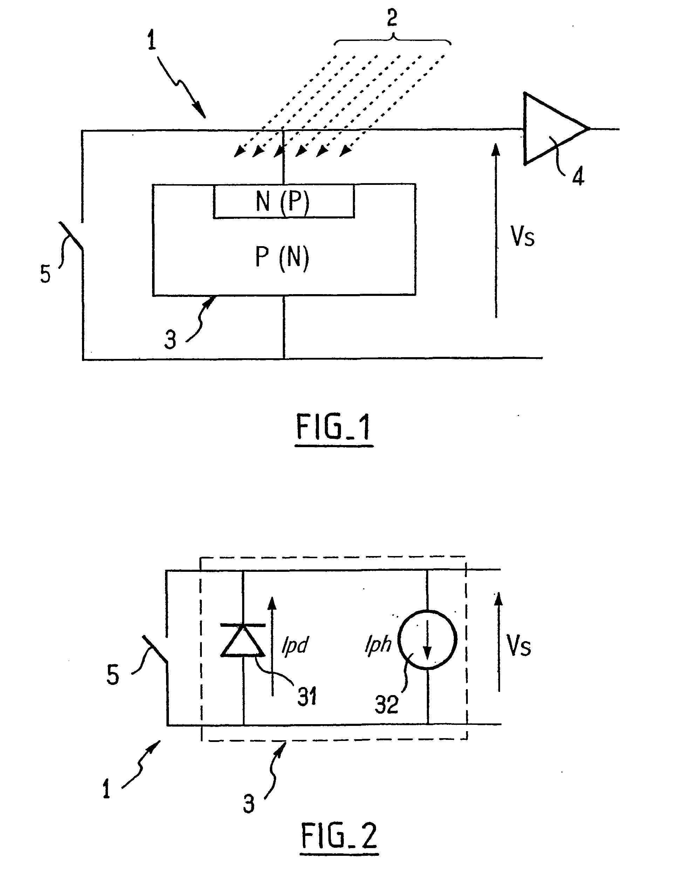

En référence à la figure 1, l'élément photoélectrique 1 comporte une jonction 3, un amplificateur 4 ainsi qu'un interrupteur 5.

La jonction 3 comporte un substrat semi-conducteur de type P ou N sur lequel est réalisée une diffusion de type N ou P. La jonction entre ces deux types de matériaux semi-conducteurs forment une jonction PN qui sert à la conversion photoélectrique. Lorsque la jonction PN 3 est soumise à un rayonnement lumineux 2, une tension Vs se crée entre les deux bornes de la jonction. C'est le principe d'une photopile. Une telle jonction PN est décrite en détail dans l'article de Yang Ni, Frédéric Lavainne, François Devos, "CMOS compatible Photoreceptor for high-contrast car vision" Intelligent Vehicle Highway Systems, SPIE' International Symposium of Photronics for Industrial Applications Vehicles, Octobre-Novembre 1994, Boston, p. 246 à 252, à laquelle on pourra se référer.

La figure 2 illustre un modèle simplifié mais pertinent du fonctionnement d'une jonction PN sous une illumination 2. Selon ce modèle, la jonction PN 3 se comporte comme une diode 31 traversée par un courant Ipd et par un générateur de courant en 32 engendrant un courant Iph. On considère que l'interrupteur 5 est ouvert, comme illustré sur les figures 1 et 2. Selon les lois de Kirchoff, le modèle de la figure 2 conduit à exprimer l'équation suivante :

$$ Ipd - Iph = 0 \qquad (1) $$

où :

$$ Ipd = Is\left( e^{\frac{Vs}{Vt}} - 1 \right) \qquad (2) $$

En intégrant l'équation (2) dans l'équation (1), on arrive à l'expression suivante :

$$ Vs = Vt \ln\left( \frac{Is + Iph}{Is} \right) \qquad (3) $$

Dans les équations précédentes, Vt est le potentiel thermique d'une jonction PN, *Is* est le courant de fuite d'une jonction PN et *Iph* est le courant photoélectrique engendré par les photons incidents de l'illumination 2 d'une jonction PN 3.

La tension de sortie Vs de l'élément photoélectrique 1 est lue par un amplificateur à impédance d'entrée infinie en courant continu 4. Un certain gain en tension peut y être éventuellement associé.

Selon l'équation (3), on peut remarquer que la tension Vs=0 correspond à un signal de sortie sans illumination optique, c'est-à-dire pour lequel *Iph* est égal à zéro. Un tel courant *Iph* nul est facilement obtenu en utilisant l'interrupteur 5 en position fermée, ce qui court-circuite la jonction PN 3 et ce, quelle que soit l'illumination 2 atteignant ladite jonction PN 3. En conséquence, on obtient de manière simple une tension de référence Vs=0 correspondant à une obscurité absolue. Cette tension de référence permet de compenser le bruit spatial fixe induit par l'amplificateur 4. Le principe de compensation de ce bruit spatial fixe est le suivant : on lit la tension de sortie après amplification par l'amplificateur 4 de l'élément photoélectrique, puis on ferme l'interrupteur 5 pour simuler une obscurité absolue, puis on relit la tension de sortie après amplification par l'amplificateur 4 de l'élément photoélectrique 1; enfin, on réalise une soustraction entre ces deux tensions lues pour avoir un signal exempt de bruit spatial fixe.

Bien entendu, la qualité de la compensation du bruit spatial fixe dépend de la nature de ce bruit et d'autre part de la linéarité de la fonction de transfert de l'ensemble de la chaîne de lecture. Cependant, dans un circuit en technologie CMOS, le bruit spatial fixe est principalement additif et induit par l'amplificateur 4. Une très bonne linéarité de l'amplificateur 4 peut être obtenu avec une conception électrique adéquate. En conséquence, il est possible de compenser le bruit spatial fixe directement à l'intérieur d'un capteur logarithmique sans faire appel à des circuits mixtes externes qui sont chers et encombrants. De plus, cette compensation se fait avec une image de référence fraîche à chaque acquisition d'images, ce qui garantie un résultat de compensation stable et efficace vis-à-vis d'éventuelles variations de l'environnement, comme un changement de température, un changement dans la tension d'alimentation, etc.

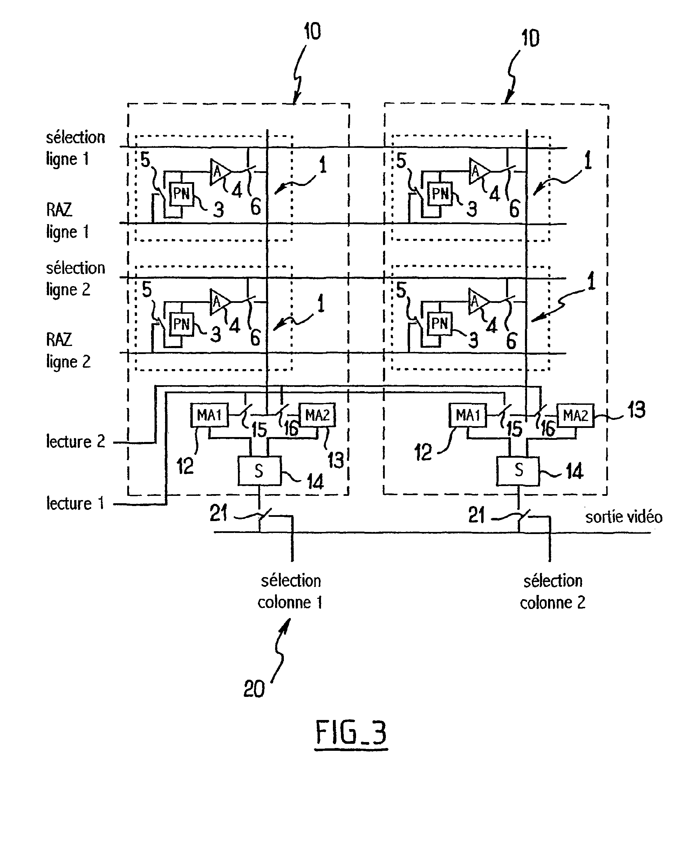

En référence à la figure 3, une matrice 20 de capteur d'images comporte un pluralité de colonnes 10 d'éléments photoélectriques 1 à la sortie de chacune desquelles un interrupteur 21 contrôlé en permet la sélection. On a représenté, sur la figure 3, que deux colonnes 10. Chaque colonne 10 constitue un photocapteur qui comporte une pluralité d'éléments photoélectriques 1 (la figure 3 n'en représente que deux) à la sortie de chacun desquels un interrupteur commandé 6 en permet la sélection. L'interrupteur 5 de chacun des éléments photoélectriques 1 est contrôlé par une ligne de commande de remise à zéro (RAZ). Les sorties de chaque élément photoélectrique 1, après leur interrupteur 6 respectif, sont dirigées toutes vers une dérivation comportant deux interrupteurs commandés indépendamment 15 et 16. L'interrupteur 15 est apte à relier les sorties des interrupteurs 6 à un élément de mémoire analogique 12. De même, l'interrupteur 16 est apte à relier les interrupteurs 6 à un second élément de mémoire analogique 13. Les sorties des deux éléments de mémoire analogique 12 et 13 sont appliquées aux entrées d'un amplificateur différentiel 14. Cet amplificateur différentiel 14 est chargé de calculer la différence entre le contenu de l'élément de mémoire analogique 12 et celui de l'élément de mémoire analogique 13. La sortie de l'amplificateur différentiel 14 est reliée a un interrupteur de sélection 21.

Le principe d'utilisation de la matrice de capteur d'image illustré à la figure 3 est le suivant :

a) On active le signal "sélection ligne 1" afin de sélectionner tous les éléments photoélectriques 1 de la ligne 1 en fermant les interrupteurs 6 respectifs. Une fois cette ligne 1 sélectionnée, on active le signal "lecture 1" qui va fermer les interrupteurs commandés 15 dans le but de mémoriser les tensions de la première lecture dans la mémoire analogique 12. Cette première lecture enregistre à la fois l'image et le bruit spatial fixe.

b) On active alors le signal RAZ ligne 1, signal qui va provoquer la fermeture des interrupteurs 5 de chacun des éléments photoélectriques 1 de la ligne 1. Les jonctions PN 3 étant ainsi court-circuitées, on simule ainsi une image de référence en obscurité absolue.

c) On active alors le signal de lecture 2, le signal de lecture 1 étant désactivé réouvrant les interrupteurs 15, pour fermer les interrupteurs 16 et ainsi enregistrer dans l'élément de mémoire analogique 13 les tensions de la deuxième lecture. On a ainsi mémorisé le bruit spatial fixe seul.

d) On calcule la différence entre le résultat des deux mémorisations contenues dans les éléments de mémoire analogique 12 et 13 respectives par un amplificateur différentiel 14. Le signal de sortie de cet amplificateur 14 correspond alors à une image exempte de bruit spatial fixe.

e) On active alors successivement les signaux de sélection de colonne pour pouvoir sortir la ligne 1 de la matrice par les interrupteurs 21.

f) On répète cette procédure de a) à d) pour la ligne 2 suivante.

g) On reprend à l'étape a) pour une nouvelle image.

Bien sûr, l'ordre de lecture des lignes peut être régulier ou aléatoire suivant les applications visées. D'autre part, les photocapteurs 10 peuvent être positionnés en ligne ou en colonne.

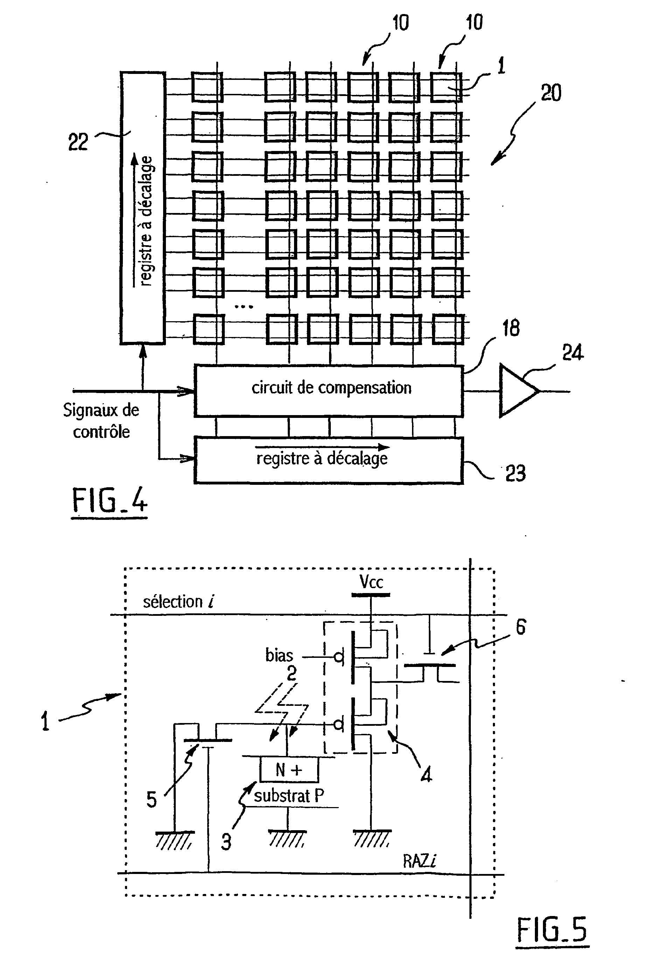

En référence à la figure 4, de manière générale, la matrice 20 de capteur d'images comporte une pluralité de photocapteurs 10 positionnés, ici, en colonne les uns à côté des autres. Elle comporte en outre un premier registre à décalage 22 qui va permettre de sélectionner les lignes d'éléments photoélectriques 1, ainsi que d'effectuer la remise à zéro de ces lignes de manière sélective. De même, la matrice 20 comporte un second registre à décalage 23 qui va permettre de contrôler sélectivement les différents interrupteurs 21 responsables de la sélection des colonnes, donc des différents photocapteurs 10 dans l'exemple illustré. Le circuit de compensation 18 regroupe l'ensemble des éléments de mémoire analogique 12 et 13 ainsi que l'ensemble des amplificateurs différentiels 14 de chacun des photocapteurs 10. La sortie 24 du circuit de compensation 18 correspond à la sortie vidéo par lequel l'image finale sera acheminée pour traitement ultérieur.

Un exemple de réalisation pratique d'un élément photoélectrique 1 est illustré à la figure 5. Les différents éléments ont la même numérotation que dans les figures précédentes. La jonction PN 3 est constituée d'un substrat semi-conducteur de type P sur lequel est réalisée une diffusion de type N. L'interrupteur 5 ainsi que l'interrupteur 6 sont constitués par des transistors à effet de champ MOS à canal N. Enfin, l'amplificateur tampon 4 est réalisé par deux transistors à effet de champ MOS à canal P en série, alimentés par une tension d'alimentation VCC, le premier transistor étant relié à une tension bias permettant de régler le gain en tension supplémentaire qu'on veut apporter à la tension de sortie Vs. Cette tension Vs est reliée au second transistor à effet de champ MOS à canal P de l'amplificateur 4.

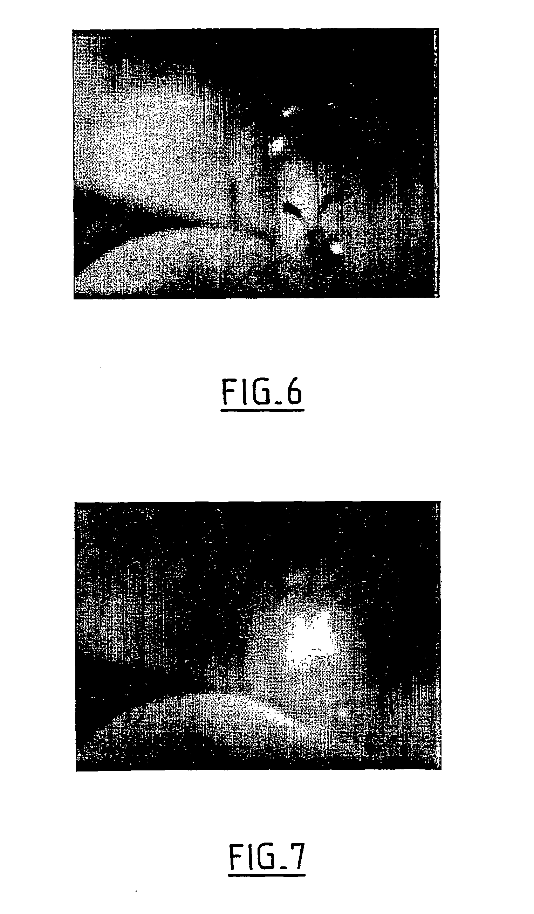

Deux exemples d'images prises par une matrice de capteur d'images selon l'invention sont illustrés aux figures 6 et 7. La figure 6 illustre une ampoule électrique éteinte, alors que la figure 7 illustre cette même ampoule, mais allumée.

On pourra bien évidemment apporter de nombreuses modifications à l'invention sans pour autant sortir du cadre de celle-ci.

Les éléments de mémorisation analogique peuvent être soit dans chaque élément photoélectrique, soit sur le bord de la matrice de capteur d'image, soit fusionnés avec les autres circuits selon la convenance de l'utilisateur de l'invention. Les amplificateurs tampons 4 peuvent être insérés n'importe où dans la chaîne de signal selon la convenance de l'utilisateur de l'invention.

Les amplificateurs différentiels peuvent être mis soit dans chaque élément photoélectrique, soit sur le bord de la matrice de capteur d'images, soit fusionnés avec les autres circuits électroniques selon la convenance de l'utilisateur de l'invention.

Les éléments de mémorisation analogiques peuvent être remplacés par des convertisseurs analogique/numérique à la sortie desquels sont connectés des éléments de mémorisation numériques.

## Revendications

1. Photocapteur comportant

   - au moins un élément photoélectrique comprenant en combinaison :
   - une jonction PN (3) opérant en mode photovoltaïque,
   - un amplificateur tampon (4) à impédance d'entrée infinie en courant continu, aux bornes d'entrée duquel la jonction PN est reliée, et
   - un interrupteur (5) commandé pour sélectivement créer un court-circuit de la jonction PN et simuler une condition d'obscurité de l'élément photoélectrique.
   - des moyens (6) pour sélectionner l'élément photoélectrique ; le photocapteur étant **caractérisé en ce qu'**il comporte
   - des moyens (14) pour combiner une lecture de l'élément photoélectrique, interrupteur (5) ouvert, et une lecture de l'élément photoélectrique, interrupteur fermé.

2. Photocapteur selon la revendication 1, **caractérisé en ce qu'**il comporte au moins un moyen de mémorisation (12, 13) pour mémoriser l'une des deux lectures.

3. Photocapteur selon la revendication 2, **caractérisé en ce que** les moyens de combinaison (14) comprennent un circuit différentiateur.

4. Photocapteur selon la revendication 2 ou 3, **caractérisé en ce que** le ou chaque élément de mémorisation (12, 13) est analogique.

5. Photocapteur selon la revendication 2 ou 3, **caractérisé en ce que** le ou chaque élément de mémorisation (12, 13) est numérique.

6. Photocapteur selon l'une des revendications 2 à 5, **caractérisé en ce qu'**il comporte deux éléments de mémorisation (12, 13).

7. Capteur matriciel d'images, **caractérisé en ce qu'**il comporte une pluralité de photocapteurs selon l'une des revendications 1 à 6.

8. Procédé de lecture destiné à être mis en oeuvre dans un photocapteur selon l'une des revendications 1 à 6,
   **caractérisé en ce qu'**il comprend les étapes suivantes :

   - sélection d'un élément photoélectrique (1);
   - première lecture de l'élément photoélectrique avec son interrupteur (5) dans une première position ;
   - mémorisation de la lecture dans l'élément de mémorisation (12, 13) ;
   - deuxième lecture de l'élément photoélectrique avec son interrupteur dans une seconde position ; et,
   - combinaison des première et seconde lectures par les moyens de combinaison (14), pour obtenir un signal de sortie.

9. Procédé de lecture selon la revendication 8, **caractérisé en ce que** la combinaison est une différence.

10. Procédé de lecture selon la revendication 8 ou 9 en combinaison avec la revendication 5 **caractérisé en ce qu'**il comprend en outre une étape de mémorisation de la deuxième lecture dans le second élément de mémorisation.

11. Procédé de lecture destiné à être mis en oeuvre dans un capteur matriciel selon la revendication 7 **caractérisé en ce qu'**il comporte les étapes suivantes :

    - sélection d'un photocapteur (10); et
    - mise en oeuvre du procédé selon l'une des revendications 8 à 10 dans le photocapteur sélectionné.

## Claims

1. A photosensor including

   - at least one photoelectric component comprising as a combination :

     - a PN junction (3) operating in a photovoltaic mode,
     - a buffer amplifier (4) with an infinite DC input impedance, to the input terminals of which the PN junction is connected, and
     - a switch (5) controlled in order to selectively create a short circuit of the PN junction and simulate a darkness condition of the photoelectric component,
- means (6) for selecting the photoelectric component;
the photosensor being **characterized in that** it includes

- means (14) for combining a reading of the photoelectric component with the switch (5) open and a reading of the photoelectric component with the switch closed.

2. The photosensor according to claim 1, **characterized in that** it includes at least one memory storage means (12, 13) for storing one of both readings in memory.

3. The photosensor according to claim 2, **characterized in that** the combination means (14) comprise a differentiator circuit.

4. The photosensor according to claim 2 or 3, **characterized in that** the or each memory storage component (12, 13) is analog.

5. The photosensor according to claim 2 or 3, **characterized in that** the or each memory storage component (12, 13) is digital.

6. The photosensor according to any of claims 2 to 5, **characterized in that** it includes two memory storage components (12, 13).

7. An image matrix sensor, **characterized in that** it includes a plurality of photosensors according to any of claims 1 to 6.

8. A reading method intended to be applied in a photosensor according to any of claims 1 to 6, **characterized in that** it comprises the following steps:

- selecting a photoelectric component (1);
- firstly reading the photoelectric component with its switch (5) in a first position;
- storing in memory the reading in the memory storage component (12, 13);
- secondly reading the photoelectric component with its switch in a second position; and,
- combining first and second readings by the combination means (14) in order to obtain an output signal.

9. The reading method according to claim 8, **characterized in that** the combination is a difference.

10. The reading method according to claim 8 or 9, combined with claim 5, **characterized in that** it further comprises a step for storing in memory the second reading into the second memory storage component.

11. The reading method intended to be applied in a matrix sensor according to claim 7, **characterized in that** it includes the following steps:

- selecting a photosensor (10); and
- applying the method according to any of claims 8 to 10 in the selected photosensor.

**Patentansprüche**

1. Photosensor umfassend:

- zumindest ein photoelektrisches Element, das kombiniert folgendes umfasst:
- einen PN Übergang (3), der im photovoltaischen Betrieb arbeitet,
- einen Pufferverstärker (4) mit unendlicher Eingangsimpedanz beim Gleichstrom, an dessen Eingangsklemme der PN Übergang verbunden ist, und
- einen Schalter (5), der gesteuert wird, um selektiv einen Kurzschluss des PN Übergangs zu erzeugen und eine Dunkelheitsbedingung des photoelektrischen Elementes zu simulieren,
- Mittel (6) zur Auswahl des photoelektrischen Elementes, wobei der Photosensor **dadurch gekennzeichnet ist, dass** er
- Mittel (14) zum Kombinieren eines Lesens des photoelektrischen Elements bei offenem Schalter (5) und eines Lesens des photoelektrischen Elementes bei geschlossenem Schalter umfasst.

2. Photosensor nach Anspruch 1, **dadurch gekennzeichnet, dass** er zumindest ein Speicherungsmittel (12, 13) umfasst, um einen der beiden Lesevorgänge zu speichern.

3. Photosensor nach Anspruch 2, **dadurch gekennzeichnet, dass** die Mittel zum Kombinieren (14) einen differenzierenden Kreis umfassen.

4. Photosensor nach Anspruch 2 oder 3, **dadurch gekennzeichnet, dass** das oder jedes Speicherungselement (12, 13) analogisch ist.

5. Photosensor nach Anspruch 2 oder 3, **dadurch gekennzeichnet, dass** das oder jedes Speicherungselement (12, 13) numerisch ist.

6. Photosensor nach einem der Ansprüche 2 bis 5, **dadurch gekennzeichnet, dass** er zwei Speicherungselemente (12, 13) umfasst.

**7.** Bild-Matrixsensor, **dadurch gekennzeichnet; dass** er eine Vielzahl von Photosensoren nach einem der Ansprüche 1 bis 6 umfasst.

**8.** Leseverfahren, das dazu vorgesehen ist, in einem Photosensor nach einem der Ansprüche 1 bis 6 eingesetzt zu werden, **dadurch gekennzeichnet, dass** es folgende Schritte umfasst:

- Auswahl eines photoelektrischen Elementes (1);
- erstes Lesen des photoelektrischen Elementes mit seinem Schalter (5) in einer ersten Stellung;
- Speicherung der Ablesung im Speicherungselement (12, 13);
- zweites Lesen des photoelektrischen Elementes mit seinem Schalter in einer zweiten Stellung; und
- Kombinierung des ersten Lesens und des zweiten Lesen durch die Kombinierungsmittel (14), um ein Ausgangssignal zu erhalten.

**9.** Leseverfahren nach Anspruch 8, **dadurch gekennzeichnet, dass** die Kombinierung eine Differenz ist.

**10.** Leseverfahren nach Anspruch 8 oder 9, kombiniert mit Anspruch 5, **dadurch gekennzeichnet, dass** es des Weiteren einen Schritt der Speicherung des zweiten Lesens im zweiten Speicherungselement umfasst.

**11.** Leseverfahren, das dazu vorgesehen ist, in einem Matrixsensor nach Anspruch 7 eingesetzt zu werden, **dadurch gekennzeichnet, dass** es die folgenden Schritte umfasst:

- Auswahl eines Photosensors (10); und
- Einsatz des Verfahrens nach einem der Ansprüche 8 bis 10 im ausgewählten Photosensor.

FIG_1

FIG_2

FIG_3

22 — registre à décalage

Signaux de contrôle

circuit de compensation

registre à décalage

FIG.4

sélection *i*

Vcc

bias

N +

substrat P

RAZ*i*

FIG.5

FIG.6

FIG.7

## RÉFÉRENCES CITÉES DANS LA DESCRIPTION

**Documents brevets cités dans la description**

- US 4633086 A

**Littérature non-brevet citée dans la description**

- Development of an Image Sensor with Enhanced Dynamic Range in Standard CMOS Technology. **U. SEGER et al.** Proc. of Second Prometheus Workshop. Institut for Microeletronics, 1989, vol. II, 371

- **YANG NI ; FRÉDÉRIC LAVAINNE ; FRANÇOIS DEVOS.** CMOS compatible Photoreceptor for high-contrast car vision. *Intelligent Vehicle Highway Systems, SPIE' International Symposium of Photronics for Industrial Applications Vehicles,* Octobre 1994, 246-252